# EUROPEAN PATENT APPLICATION

(11) **EP 4 645 587 A1**
(43) Date of publication of application: **05.11.2025**
(21) Application number: 23958389.1
(22) Date of filing: 08.11.2023
(51) Int. Cl.: H01Q 1/02, H05K 7/20, H01Q 1/32, H05K 1/02, H01Q 25/00, H01Q 21/00, G01S 13/00, G01S 7/00

(54) **ANTENNA STRUCTURE MOUNTED ON VEHICLE**

(71) Applicant: LG Electronics Inc., Yeongdeungpo-gu Seoul 07336 (KR)
(72) Inventor: WOO, Changsik, Seoul 06772 (KR)
(74) Representative: Vossius & Partner Patentanwälte Rechtsanwälte mbB
(86) International application number: PCT/KR2023/017861
(87) International publication number: WO 2025/100588

(57) **Abstract**

This antenna structure comprises: a PCB on which electronic components of a first communication system are disposed; a first cover disposed below the PCB and formed as a metal plate; a second cover configured to be coupled to the lower cover and accommodate the PCB therein; a second PCB which is operably coupled to the PCB and on which electronic components of a second communication system are disposed; a first heat sink formed in a first opening area of a first region of the second cover; a third cover coupled to a second region of the second cover and configured to accommodate the second PCB therein; and a second heat sink formed in a second opening area of the third cover.

## Description

### Technical Field

The present disclosure relates to an antenna structure mounted on a vehicle. A particular implementation relates to an antenna structure having a plurality of communication modules and a heat dissipation structure, and a vehicle including the antenna structure.

### Background Art

Electronic devices may be classified into mobile/portable terminals and stationary terminals according to mobility. Meanwhile, with commercialization of wireless communication systems that use LTE communication technologies, in recent years, the electronic devices have provided various services. In addition, in the future, it is also expected that the electronic devices may provide various services, with commercialization of wireless communication systems that use 5G communication technologies. Meanwhile, some of LTE frequency bands may be allocated to provide 5G communication services.

In this regard, mobile terminals may be configured to provide 5G communication services in various frequency bands. Recently, attempts have been made to provide 5G communication services using a Sub6 band that is a band of 6 GHz or less. In the future, however, it is also expected to provide 5G communication services by using a millimeter-wave (mmWave) band in addition to the Sub6 band for a faster data rate.

Recently, a need to provide these communication services through a vehicle has been increased. Meanwhile, regarding communication services, there has also appeared a need for fifth-generation (5G) communication services that are next-generation services, as well as for existing communication services, such as long-term evolution (LTE) services.

Meanwhile, a vehicle body and roof are made of metallic material, which causes a problem with blocking radio waves. Accordingly, a separate antenna structure may be placed on the vehicle body or the vehicle roof. Alternatively, when an antenna structure is arranged on a bottom of the vehicle body or roof, a portion of the vehicle body or roof corresponding to a region where the antenna structure is arranged may be made of a non-metallic material.

However, in terms of design, the vehicle body or roof needs to be integrally disposed. In this case, the exterior of the vehicle body or roof may be made of a metallic material. This may cause antenna efficiency to be drastically lowered due to the vehicle body or roof.

Additionally, the antenna structure mounted on the vehicle may include a plurality of communication modules. Arrangement structures of the plurality of communication modules may be placed on different substrates. An optimal heat dissipation structure in consideration of the arrangement structures of the communication modules placed on different substrates is needed.

### Disclosure of Invention

### Technical Problem

The present disclosure is directed to solving the aforementioned problems and other drawbacks. In addition, another objective of the present disclosure is to provide an antenna structure including a plurality of communication modules and a heat dissipation structure in a vehicle.

Another objective of the present disclosure is to implement an optimal heat dissipation structure by taking into account arrangement structures of communication modules placed on different substrates.

Another objective of the present disclosure is to provide an interface structure for signal and power connections between substrates having different electronic components arranged thereon.

Another objective of the present disclosure is to improve antenna performance while maintaining a height of the antenna structure mounted on the vehicle at a certain level or greater.

Another objective of the present disclosure is to apply an arrangement structure of an antenna capable of operating in a wide band to a vehicle to support various communication systems.

### Solution to Problem

To achieve these and other advantages and in accordance with the purpose of this specification, as embodied and broadly described herein, there is provided an antenna structure mounted on a vehicle, the antenna structure including: a printed circuit board (PCB) on which electronic components of a first communication system are arranged; a first cover arranged below the PCB and made of a metal plate; a second cover coupled to the lower cover and configured to accommodate the PCB therein; a second PCB operably coupled to the PCB and having electronic components of a second communication system arranged thereon; a first heat sink arranged in a first opening area of a first region of the second cover; a third cover coupled to a second region of the second cover and configured to accommodate the second PCB therein; and a second heat sink arranged in a second opening area of the third cover.

According to an embodiment, the first heat sink may include: a first metal structure stacked to be in contact with a shield can of an integrated circuit of the PCB; second metal structures arranged to be perpendicular to the first metal structure and configured in plurality in a first direction; and a third metal structure arranged to be inclined to connect end portions of the first metal structure to both side surfaces of the first opening area.

According to an embodiment, the second heat sink may include: a fourth metal structure stacked to be in contact with a shield can of an integrated circuit of the second PCB; fifth metal structures connected to the fourth metal structure and configured in plurality to be parallel with each other in a second direction different from the first direction; and a sixth metal structure arranged to be inclined to connect end portions of the fourth metal structure to both side surfaces of the second opening area.

A vehicle having an antenna structure according to another aspect of this specification mounted thereon is provided. The vehicle includes: an antenna structure arranged below a roof of the vehicle; and a telematics module operably coupled to the antenna structure and configured to communicate with at least one among an adjacent vehicle, a road side unit (RSU), and a base station. The antenna structure includes: a printed circuit board (PCB) on which electronic components of a first communication system are arranged; a first cover arranged below the PCB and made of a metal plate; a second cover coupled to the lower cover and configured to accommodate the PCB therein; a second PCB operably coupled to the PCB and having electronic components of a second communication system arranged thereon; a first heat sink arranged in a first opening area of a first region of the second cover; a third cover coupled to a second region of the second cover and configured to accommodate the second PCB therein; and a second heat sink arranged in a second opening area of the third cover.

### Advantageous Effects of Invention

Hereinafter, technical effects of such an antenna structure mounted on a vehicle and the vehicle including the antenna structure are described.

According to this specification, an antenna structure having a plurality of communication modules and a heat dissipation structure may be provided in a vehicle.

According to this specification, an optimal heat dissipation structure may be implemented by taking into account arrangement structures of communication modules placed on different substrates.

According to this specification, a direction in which metal structures of first and second heat sinks are arranged may be configured to be aligned with a polarization direction of an antenna to implement optimal heat dissipation performance.

According to this specification, an interface structure and a board-to-board connector structure each for signal and power connections between substrates having different electronic components arranged thereon may be provided.

According to this specification, in an antenna structure, upper end portions of a second cover and a third cover which are coupled to a first cover in different regions, respectively, may be configured to be located at a same height, thereby improving antenna performance while maintaining a height of the antenna structure mounted on a vehicle at a certain level or below.

According to this specification, an antenna structure in which antenna elements capable of operating in a wide band are optimally arranged on different printed circuit boards (PCBs) may be applied to a vehicle to support various communication systems.

Further scope of applicability of the present disclosure will become apparent from the following detailed description. It should be understood, however, that the detailed description and specific examples, such as the preferred embodiment of the present disclosure, are given by way of illustration only, since various changes and modifications within the spirit and scope of the present disclosure will be apparent to those skilled in the art.

### Brief Description of Drawings

FIG. 1 is a diagram illustrating a vehicle according to an embodiment of this specification.
FIGS. 2A to 2B illustrate a structure in which an antenna structure may be mounted on a vehicle according to this specification, the vehicle having the antenna structure mounted thereon.
FIG. 3 is a configuration diagram of the vehicle according to an embodiment of this specification.
FIG. 4 is a diagram illustrating modules that may be arranged on different substrates of an antenna structure for a vehicle, and an interface structure between the modules.
FIG. 5 is an exploded perspective view of the antenna structure of FIG. 4.
FIG. 6 illustrates a structure in which the antenna structure of FIG. 4 is coupled to a network access device (NAD) module.
FIG. 7A is a perspective view illustrating coupling of a second cover including a first heat sink to a first cover.
FIG. 7B is a cross-sectional view of the second cover including the first heat sink of FIG. 7A, the second cover taken along line AA' in a first axis direction.
FIG. 8A is a perspective view illustrating coupling of a third cover including a second heat sink to the first cover.
FIG. 8B is a cross-sectional view of the second cover including the second heat sink of FIG. 8A, the second cover taken along line BB' in the first axis direction.
FIG. 9 illustrates a structure in which interface terminals are exposed to outside on one side surface of the antenna structure according to this specification.
FIG. 10 is a diagram illustrating a board-to-board connector structure connecting printed circuit boards (PCBs) of the antenna structure according to this specification.
FIG. 11 illustrates a structure in which a plurality of electronic components are arranged on front and rear surfaces of a PCB of the antenna structure according to this specification.
FIG. 12 illustrates a structure in which a plurality of electronic components are arranged on front and rear surfaces of a second PCB of the antenna structure according to this specification.
FIG. 13 is an enlarged view of the PCB of the antenna structure according to this specification and a region in which the antenna element for UWB communication is arranged.
FIG. 14 illustrates magnified front and rear views of the region of the PCB in which the antenna element for UWB communication shown in FIG. 13 is arranged.
FIG. 15 is a block diagram including a plurality of antenna elements for 4G/5G communications in the antenna structure according to this specification.
FIG. 16 is a configuration diagram of a vehicle including the antenna structure according to this specification.

### Mode for the Invention

Hereinafter, embodiments disclosed herein will be described in detail with reference to the accompanying drawings, and the same or similar elements are designated with the same numeral references, regardless of the numerals in the drawings, and their redundant description will be omitted. Suffixes "module" and "unit" used for components used in the following description are merely intended for easy description of this specification, and each suffix itself is not intended to give any special meaning or function. In describing the embodiments disclosed herein, moreover, the detailed description will be omitted when specific description for publicly known technologies to which the disclosure pertains is judged to obscure the gist of this specification. The accompanying drawings are used to help easily understand the technical idea of this specification and it should be understood that the idea of this specification is not limited by the accompanying drawings. The idea of this specification should be construed to extend to any alterations, equivalents and substitutes besides the accompanying drawings.

It will be understood that although the terms first, second, etc. may be used herein to describe various elements, these elements should not be limited by these terms. These terms are generally only used to distinguish one element from another.

It will be understood that when an element is referred to as being "connected" or "coupled" to another element, the element may be directly connected or coupled to the another element, or intervening elements may also be present. In contrast, when an element is referred to as being "directly connected with" another element, there are no intervening elements present.

A singular representation may include a plural representation unless it represents a definitely different meaning from the context.

Terms such as "include" or "has" as used herein should be understood that they are intended to indicate the existence of a feature, a number, a step, an element, a component, or a combination thereof disclosed in this specification, and it may also be understood that a possibility of presence or addition of one or more other features, numbers, steps, elements, components, or combinations thereof are not excluded in advance.

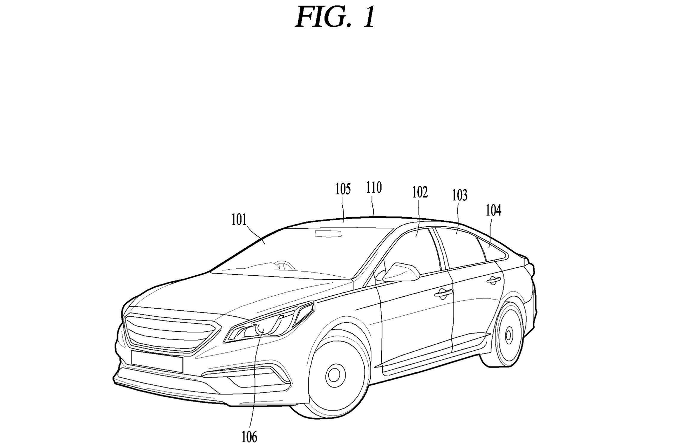

Hereinafter, an antenna module according to this specification is described in detail. In this regard, FIG. 1 is a diagram illustrating a vehicle according to an embodiment of this specification.

Referring to FIG. 1, a vehicle 1 may include at least one communication antenna. The vehicle 1 may transmit and/or receive signals of various frequency bands using the communication antenna. The vehicle 1 may perform communications such as vehicle-to-vehicle (V2V), vehicle to infrastructure (V2I), vehicle-to-pedestrian (V2P), vehicle-to-network (V2N), and the like.

The antenna may include a substrate made of a material such as olyethylene terephthalate (PET), and an antenna pattern arranged on the substrate. For example, the antenna may be a transparent antenna.

The antenna may also be placed on glass of the vehicle 1. The antenna may be coupled or attached to a front windshield 101, pieces of door glass 102 and 103, quarter glass 104, a rear windshield (not illustrated), a side mirror (not illustrated), a sunroof 105, or lamp glass 106. For example, the antenna may be a transparent antenna. As another example, the antenna may be placed in a region in which a roof 110 on an upper portion of the vehicle 1 is arranged.

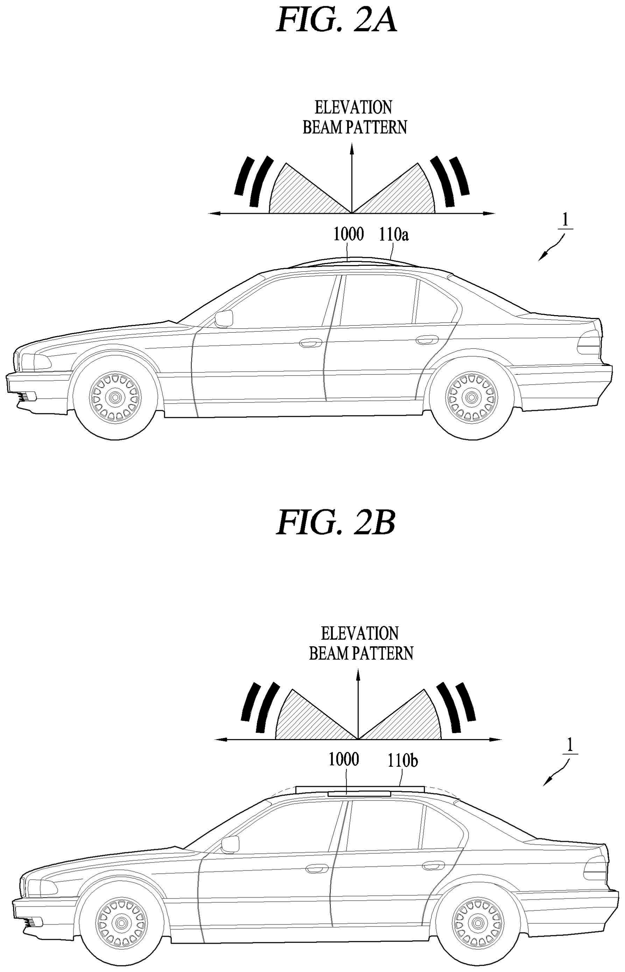

Meanwhile, FIGS. 2A to 2C illustrate a structure in which an antenna structure may be mounted on a vehicle according to this specification, the vehicle having the antenna structure mounted thereon.

Referring to FIGS. 2A to 2C, in this specification, to improve an appearance of the vehicle and maintain telematics performance during collision, a general shark fin antenna is replaced with a flat antenna having a non-protruding shape. In addition, this specification proposes an antenna in which a long term evolution (LTE) antenna and a fifth generation (5G) antenna are integrated in consideration of 5G communication while providing a general mobile communication service (LTE).

Referring to FIG. 2A, an antenna structure 1000 is arranged on a roof placed on the vehicle 1. In FIG. 2A, with respect to the antenna structure 1000, a radome 110a for protection from an external environment and external impacts while the vehicle travels may surround the antenna system 1000. The radome 110a may be made of a dielectric material capable of transmitting a radio signal sent/received between the antenna system 1000 and an infrastructure such as a base station or other vehicles.

Referring to FIG. 2B, configuration may be performed such that the antenna structure 1000 is arranged within a roof structure 110b of the vehicle 1, and at least a part of the roof structure 110b is implemented with a non-metallic material. At this time, the at least a part of the roof structure 110b of the vehicle may be implemented with a non-metallic material to include a dielectric material capable of transmitting a radio signal sent/received between the antenna system 1000 and an infrastructure such as a base station or other vehicles.

Meanwhile, referring to FIGS. 2A and 2B, a region in which a beam pattern is generated by an antenna included in the antenna structure 1000 mounted on the vehicle needs to extend to an area located upward by a predetermined angle from a horizontal region.

In this regard, a peak of an elevation beam pattern of the antenna included in the antenna structure 1000 does not need to be located along a boresight. Therefore, a peak of the elevation beam pattern of the antenna needs to extend to an area located upward by a predetermined angle from the horizontal region. For example, the elevation beam pattern of the antenna may be generated in a hemisphere shape as shown in FIGS. 2A and 2B. Additionally, since a beam peak is located within a range of low elevation angles (e.g., 30 degrees), the elevation beam pattern of the antenna may be referred to as a low elevation beam pattern.

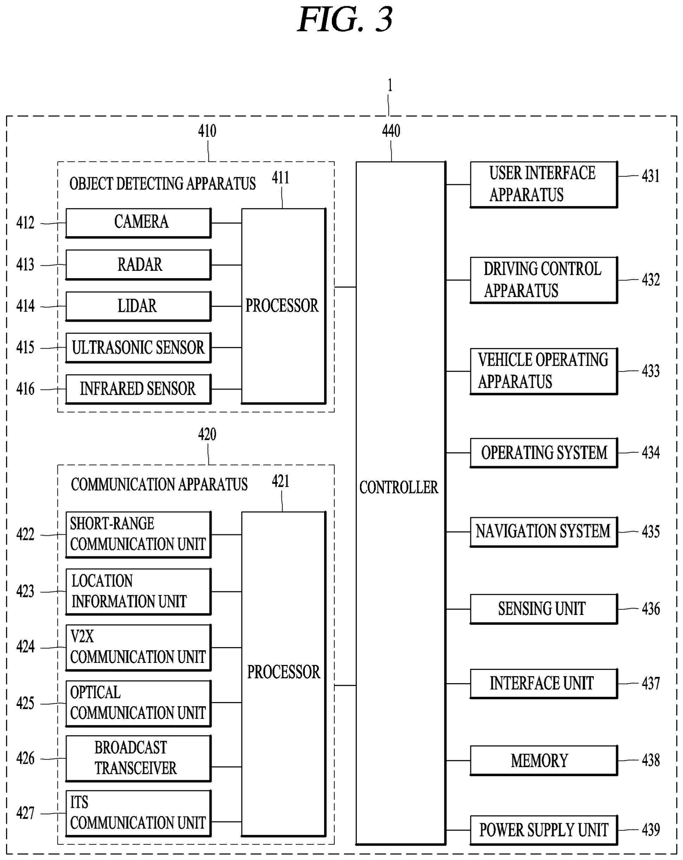

FIG. 3 is a configuration diagram of the vehicle according to an embodiment of this specification. Referring to FIG. 3, the vehicle 1 may include an object detection device 410, a communication device 420, a user interface device 431, a driving operation device 432, a vehicle drive device 433, a driving system 434, a navigation system 435, a sensing unit 436, an interface unit 437, a memory 438, a power supply unit 439, and/or a controller 440. On the other hand, the vehicle 1 may further include components other than the components described above, or some of the components described above may not be included.

The object detection device 410 may be a device for detecting an object located outside the vehicle 1. For example, the object detection device 410 may include a processor 411, a camera 412, a radar 413, a LiDAR 414, an ultrasonic sensor 415, and/or an infrared sensor 416.

The communication device 420 may be a device for performing communication with an external device. The communication device 420 may include at least one among a transmitting antenna, a receiving antenna, and a radio frequency (RF) circuit or an RF device capable of implementing various communication protocols to perform communication. For example, the communication device 420 may include a processor 421, a short-range communication unit 422, a location information unit 423, a vehicle-to-everything (V2X) communication unit 424, an optical communication unit 425, a broadcast transceiver 426 and/or an ITS communication unit 427.

The user interface device 431 may be a device for interaction between the vehicle 1 and a user. The vehicle 1 may implement a user interface (UI) or a user experience (UX) through the user interface device 431.

The driving operation device 432 may be a device for receiving a user input for driving. The vehicle drive device 433 may be a device for electrically controlling drive of various devices within the vehicle 1. The driving system 434 may be a system that controls various driving operations of the vehicle 1. The navigation system 435 may provide navigation information. The sensing unit 436 may sense a state of the vehicle 1.

The interface unit 437 may function as an interface with various types of external devices connected to the vehicle 1. The memory 438 may store basic data for units of the vehicle 1, control data for controlling operations of the units, input or output data, and the like. The power supply unit 439 may supply power needed for operations of respective components. The controller 440 may control overall operations of each unit within the vehicle 1. The controller 440 may be implemented as an electronic control unit (ECU) and/or a telematics control unit (TCU).

Meanwhile, referring to FIGS. 1 to 3, an antenna system mounted in the vehicle may be arranged inside the vehicle, on a roof of the vehicle, inside the roof, or inside a roof frame. In this regard, the antenna system disclosed herein may be configured to operate in a low band (LB), a mid band (MB), and a high band (HB) of a 4G LTE system and a SUB6 band of a 5G NR system.

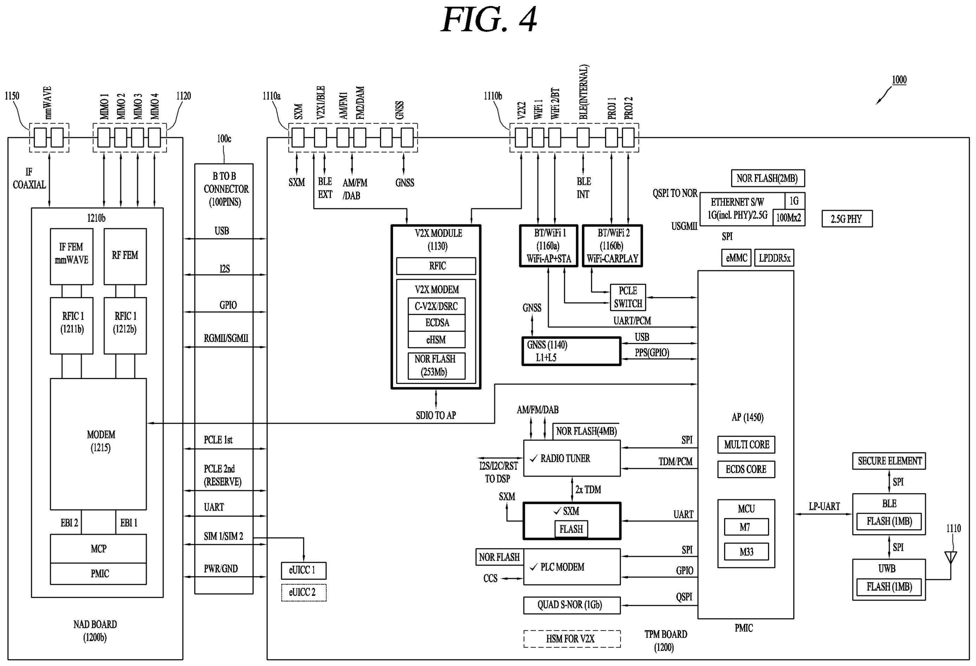

Hereinafter, a vehicle antenna structure according to this specification is to be described. In this regard, FIG. 4 is a diagram illustrating modules that may be arranged on different substrates of the vehicle antenna structure, and an interface structure between the modules.

Referring to FIG. 4, the antenna structure 1000 for a vehicle may be configured to include a first substrate 1200, a second substrate 1200b, and a board-to-board connector structure 100c. The first substrate 1200 may be implemented as a system board such as a trusted platform module (TPM). The second substrate 1200b may be implemented as a network access board such as a network access device (NAD). The first substrate 1200 and the second substrate 1200b may be implemented as a first printed circuit board (PCB) and a second PCB. The board-to-board connector structure 100c may be configured to connect a terminal of the first substrate 1200 to a terminal of the second substrate 1200b through a connector.

The first substrate 1200 may be configured to include a plurality of antenna/communication modules and a processor in addition to an antenna element 1110. A first antenna structure 1110a, a second antenna structure 1110b, a V2X module 1130, a global navigation satellite system (GNSS) module 1140, a first Wi-Fi module 1160a, a second Wi-Fi module 1160b, and an application processor (AP) 1450 may be arranged on the first substrate 1200.

The second substrate 1200b may be configured to include a plurality of antennas/communication modules and a processor for 4G/5G wireless communications and millimeter wave wireless communications. Antenna elements 1120 for multiple input/output (MIMO), an array antenna 1150 for beam forming, and an integrated circuit 1210b may be arranged on the second substrate 1200b.

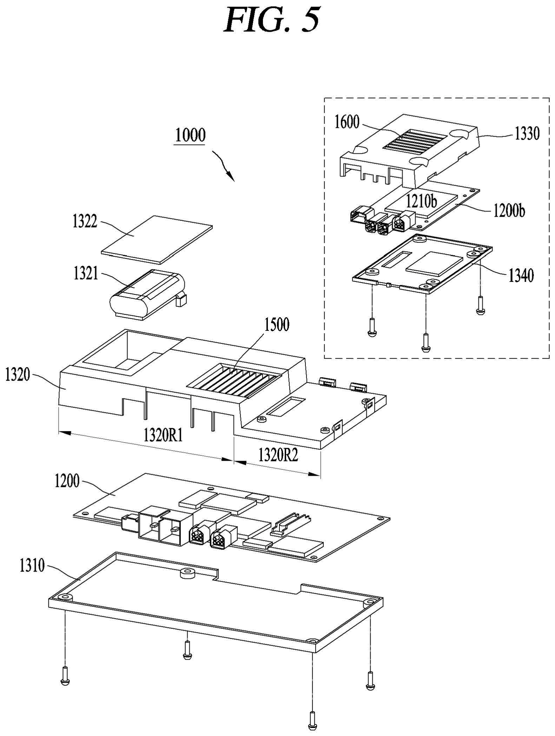

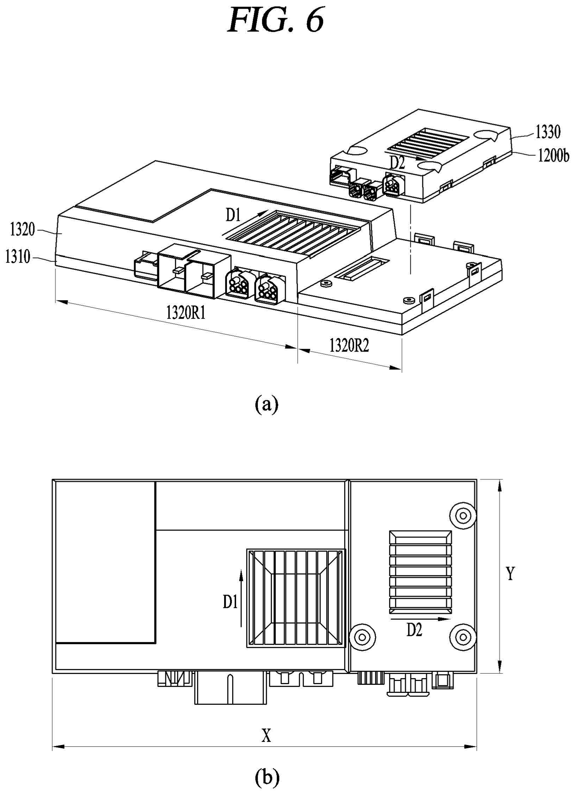

Meanwhile, FIG. 5 is an exploded perspective view of the antenna structure of FIG. 4. FIG. 6 illustrates a structure in which the antenna structure of FIG. 5 is coupled to a network access device (NAD) module. (a) of FIG. 6 is a perspective view of an antenna structure in which a third cover 1330 having an NAD module positioned therein may be coupled to one region of a second cover 1320 coupled to a first cover 1310. (b) of FIG. 6 is a front view in which the third cover 1330 is coupled to the one region of the second cover 1320.

Referring to FIGS. 4 to 6, the vehicle antenna structure 1000 according to this specification are described. The vehicle antenna structure 1000 may be configured to include the PCB 1200 on which an antenna is placed and the second PCB 1200b which is a telematics control unit (TCU) substrate on which a TCU is placed.

The vehicle antenna structure 1000 may be configured to include a plurality of covers that protect electronic components or are attached to the vehicle. The vehicle antenna structure 1000 may include the first cover 1310 corresponding to a lower cover, the second cover 1320 corresponding to an upper cover, and the third cover 1330.

The PCB 1200 may be configured to have electronic components of a first communication system arranged thereon. The second PCB 1200b may be operably coupled to the PCB 1200. The second PCB 1200b may be configured to have electronic components of a second communication system arranged thereon. The first communication system may include at least one among an LTE communication system, a V2X communication system, and a BT/WiFi communication system. The second communication system may include at least one among a 4G/5G communication system and a millimeter wave (mmWave) communication system utilizing a millimeter wave band.

The first cover 1310 may be arranged below the PCB 1200. The first cover 1310 may include a metal plate and be coupled to a structure of the vehicle. The second cover 1320 may be coupled to the first cover 1310 which is the lower cover. The second cover 1320 may be configured to have the PCB 1200 accommodated therein. The second cover 1320 may be configured to include a first region 1320R1 and a second region 1320R2. The second cover 1320 may have a first heat sink 1500 arranged on the first region 1320R1. The first cover 1310 may be coupled to the second cover 1320 through a plurality of screws that penetrate through outer holes of the PCB 1200. A battery 1321 may be stored in a storage space on one side of the first region 1320R1 of the second cover 1320, and a battery cover 1322 may be arranged on an upper portion of the storage space.

The third cover 1330 may be coupled to the second region 1320R2 of the second cover 1320. The third cover 1330 may be configured to have the second PCB 1200b accommodated therein. The third cover 1330 having the second PCB 1200b accommodated therein may be coupled to the second region 1320R2 of the second cover 1320. The third cover 1330 having the second PCB 1200b accommodated therein may be coupled to a fourth cover 1340. The second region 1320R2 of the second cover 1320 may be coupled to the third cover 1330 and the fourth cover 1340 through a plurality of screws penetrating through outer holes of the second PCB 1200b. The PCB 1200 accommodated inside the second cover 1320 may be electrically connected to the second PCB 1200b accommodated in the third cover 1330 through the board-to-board connector structure 100c.

Meanwhile, the vehicle antenna structure 1000 according to this specification may be configured to include a plurality of heat sink structures having a heat dissipation structure optimally arranged therein, in consideration of an operating state in the first and second communication systems. In relation to this, the vehicle antenna structure 1000 may be configured to include the first heat sink 1500 and a second heat sink 1600. The first heat sink 1500 may be arranged in a first opening area of the first region 1320R1 of the second cover 1320. The second heat sink 1600 may be arranged in a second opening area of the third cover 1330. The first heat sink 1500 may be arranged in plurality in a first direction D1 to reduce heat generation using a ventilation structure in the first direction D1. The second heat sink 1600 may be arranged in plurality in a second direction D2 to reduce heat generation using a ventilation structure in the second direction D2. The first heat sink 1500 in the first direction D1 may be arranged in a Y-axis direction. The second heat sink 1600 in the second direction D2 may be arranged in an X-axis direction.

Meanwhile, in the vehicle antenna structure 1000 according to this specification, the first heat sink 1500 may be arranged on an XY plane in a particular axis direction. In the vehicle antenna structure 1000, the second heat sink 1600 may be arranged on the XY plane in another axis direction perpendicular to the particular axis direction.

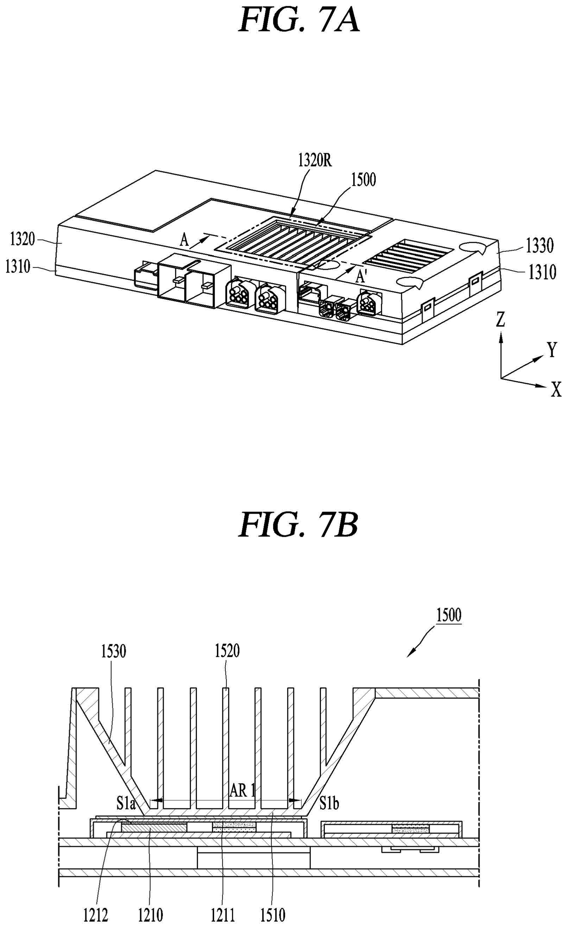

In this regard, FIG. 7A is a perspective view illustrating coupling of the second cover including the first heat sink to the second cover. FIG. 7B is a cross-sectional view of the second cover including the first heat sink of FIG. 7A, the second cover taken along line AA' in a first axis direction.

Referring to FIGS. 7A and 7B, the second cover 1320 including the first heat sink 1500 may be coupled to the first cover 1310. The first heat sink 1500 may be arranged on one region 1320R on an upper portion of the second cover 1320.

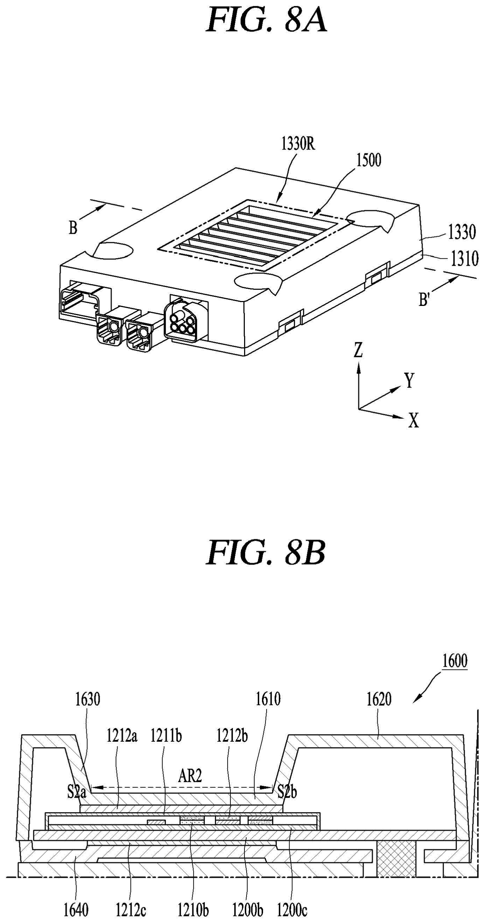

Meanwhile, FIG. 8A is a perspective view illustrating coupling of the third cover including the second heat sink to the first cover. FIG. 8B is a cross-sectional view of the second cover including the second heat sink of FIG. 8A, the second cover taken along line BB' in the first axis direction.

Referring to FIGS. 8A and 8B, the third cover 1330 including the second heat sink 1600 may be coupled to the first cover 1310. The second heat sink 1600 may be arranged on one region 1330R on an upper portion of the third cover 1320.

Referring to FIGS. 4 to 8B, the vehicle antenna structure 1000 including the first heat sink 1500 and the second heat sink 1600 is described.

The first heat sink 1500 may be configured to include a first metal structure 1510 and second metal structures 1520. The first heat sink 1500 may be configured to further include a third metal structure 1530.

The first metal structure 1510 may be stacked in a Z-axis direction to be in contact with a shield can 1211 of an integrated circuit 1210 of the PCB 1200. A thermal pad 1212 may be placed between the integrated circuit 1210 and the shield can 1211. The thermal pad 1212 may transfer heat, generated from the integrated circuit 1210, to the first heat sink 1500 through the shield can 1211. The second metal structures 1520 may be arranged to be perpendicular to the first metal structure 1510. The second metal structures 1520 may be arranged in plurality in a first direction along a Y-axis direction.

The third metal structure 1530 may be configured to connect end portions of the first metal structure 1510 to both side surfaces S1a and S1b of a first opening area (aperture region) AR1. The third metal structure 1530 may be arranged to be inclined to connect the end portions of the first metal structure 1510 to the both side surfaces S1a and S1b of the first opening area AR1.

The second heat sink 1600 may be configured to include a fourth metal structure 1610 and fifth metal structures 1620. The second heat sink 1600 may be configured to further include a sixth metal structure 1630. The second heat sink 1600 may be configured to further include a seventh metal structure 1640.

The fourth metal structure 1610 may be stacked in the Z-axis direction to be in contact with a shield can 1211b of the integrated circuit 1210b of the second PCB 1200b. A thermal pad 1212a may be arranged between the fourth metal structure 1610 and the shield can 1211b. A thermal pad 1212b may be arranged between the integrated circuit 1210b and the shield can 1211b. The integrated circuit 1210b may be arranged on a third PCB 1200c, and the third PCB 1200c covered by the shield can 1211b may be arranged on the second PCB 1200b. The thermal pads 1212a and 1212b may transfer heat, generated from the integrated circuit 1210b, to the second heat sink 1600 through the shield can 1211b.

The fifth metal structures 1620 may be connected to the fourth metal structure 1610. The fifth metal structures 1620 may be arranged in plurality in parallel with each other in a second direction different from the first direction. The fifth metal structures 1620 may be arranged in plurality in parallel with each other in the second direction along an X-axis direction.

The sixth metal structure 1630 may be arranged to connect end portions of the fourth metal structure 1610 to both side surfaces S2a and S2b of a second opening area AR2. The sixth metal structure 1630 may be arranged to be inclined to connect the end portions of the fourth metal structure 1610 to the both side surfaces S2a and S2b of the second opening area AR2. The sixth metal structure 1630 may include an inner structure arranged in an inner region, an outer structure arranged in an outer region, and a connection structure connecting the inner structure to the outer structure. The fifth metal structures 1620 may define the connection structure of the sixth metal structure 1630.

The outer structure of the sixth metal structure 1630 may have lower portions coupled to both end portions of the seventh metal structure 1640. The seventh metal structure 1640 may be arranged to be parallel with the fourth metal structure 1610 to constitute a bottom surface. A thermal pad 1212c may be arranged between the second PCB 1200b and the seventh metal structure 1640. The thermal pad 1212c may transfer heat, generated from the second PCB 1200b on which the integrated circuit 1210b is placed, to the second heat sink 1600 including the seventh metal structure 1640.

The second metal structures 1520 of the first heat sink 1500 may be arranged in plurality in a first direction in which a first signal of the first communication system is input. The fifth metal structures 1620 of the second heat sink 1600 may be arranged in plurality in a second direction in which second signals of the second communication system are input. The first direction of the second metal structures 1520 of the first heat sink 1500 may be configured as the Y-axis direction. The second direction of the fifth metal structures 1620 of the second heat sink 1600 may be configured as an X-axis direction perpendicular to the first direction.

The first communication system may be a 4G communication system such as an LTE communication system, but is not limited thereto and may vary depending on applications. For example, the second communication system may be a 5G communication system, but is not limited thereto and may vary depending on applications.

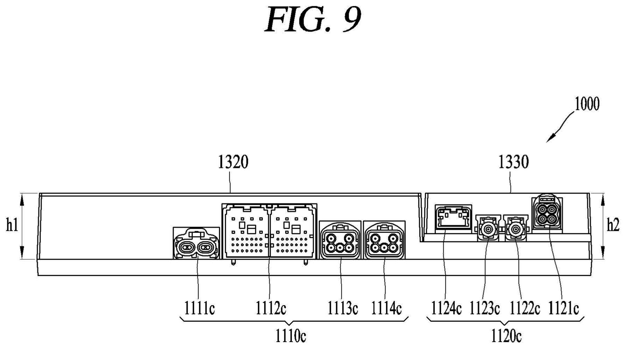

Meanwhile, interface terminals may be arranged on one side surface of the antenna structure 1000 according to this specification to be exposed to outside. In this regard, FIG. 9 illustrates a structure in which interface terminals are exposed to outside on one side surface of the antenna structure according to this specification.

Referring to FIG. 9, in the second cover 1320, the second region 1320R2 may be configured to have a smaller height than that of the first region 1320R1. The second cover 1320 may be configured in a recessed region. The second PCB 1200b and the third cover 1330 may arranged in the recessed region of the second cover 1320. An upper end portion of the second cover 1320 may be arranged at a same point on a Z-axis as an upper end portion of the third cover 1330. A height h1 from a lower end portion to the upper end portion of the second cover 1320 may be configured to be greater than a height h2 from a lower end portion to the upper end portion of the third cover 1330.

The third cover 1330 may be arranged in the recessed region of the second cover 1320, and the upper end portions of the second and third covers 1320 and 1330 may be located at a same height, thereby minimizing a whole height of the antenna structure 1000. A flat antenna structure may be implemented by implementing an external shape of the antenna structure 1000 as a planar shape while minimizing the whole height of the antenna structure 1000. By implementing the flat antenna structure while minimizing the whole height of the antenna structure 1000, the antenna structure 1000 may be arranged in a limited space inside/outside a vehicle.

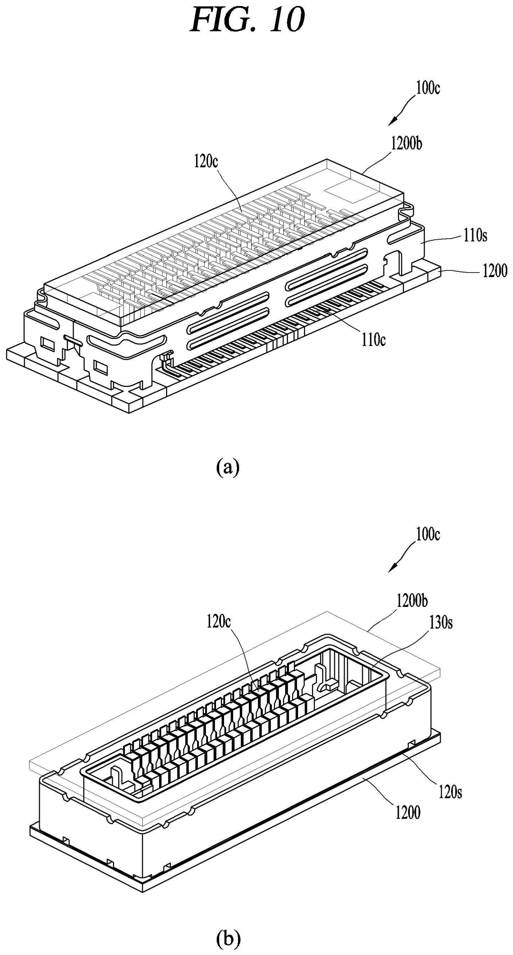

Meanwhile, the PCBs 1200 and 1200b of the antenna structure according to this specification may be connected to each other via terminals through the board-to-board connector structure 100c. In this regard, FIG. 10 is a diagram illustrating the board-to-board connector structure connecting the PCBs of the antenna structure according to this specification.

Referring to (a) of FIG. 10, the board-to-board connector structure 100c may be arranged between the PCB 1200 and the second PCB 1200b to connect the PCB 1200 to the second PCB 1200b. First connection terminals 110c of the board-to-board connector structure 100c may be coupled to terminals of the PCB 1200. Second connection terminals 120c of the board-to-board connector structure 100c may be coupled to terminals of the second PCB 1200b. A first shield structure 110s configured to have a metal structure may be arranged to surround a side surface of the board-to-board connector structure 100c. The board-to-board connector structure 100c in which the first shield structure 110s is arranged may be referred to as a half-shielded connector.

Referring to (b) of FIG. 10, in the board-to-board connector structure 100c, a second shield structure 120s may be arranged on a surface on which the PCB 1200 is placed to surround the first connection terminals 110c. In the board-to-board connector structure 100c, a third shield structure 130s may be arranged on the surface on which the second PCB 1200b is placed. Unlike the first shield structure 110s made of a metallic material, the second and third shield structures 120s and 130s may be made of a dielectric material. The board-to-board connector structure 100c in which the second and third shield structures 120s and 130s are arranged may be referred to as a full-shielded connector.

Meanwhile, the PCB 1200 and the second PCB 1200b of the antenna structure according to this specification may have a plurality of electronic components arranged on front and rear surfaces thereof. As the plurality of electronic components arranged on the front and rear surfaces of the PCB 1200 and the second PCB 1200b operate, heat is generated. Thus, there is a need to dissipate the heat to outside through a heat dissipation structure.

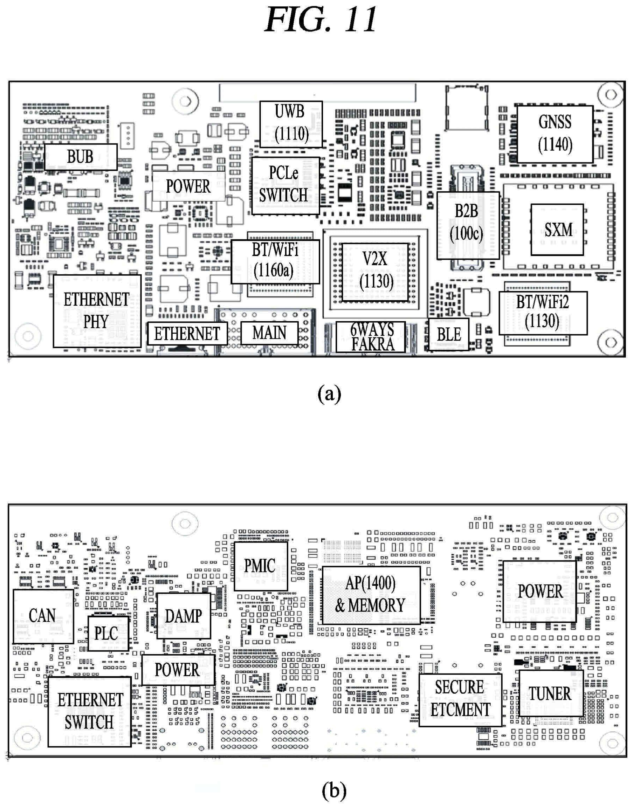

In this regard, FIG. 11 illustrates a structure in which a plurality of electronic components are arranged on front and rear surfaces of the PCB of the antenna structure according to this specification. (a) of FIG. 11 illustrates a structure in which a plurality of electronic components are arranged on the front surface of the PCB of the antenna structure. (b) of FIG. 11 illustrates a structure in which a plurality of electronic components are arranged on the rear surface of the PCB of the antenna structure.

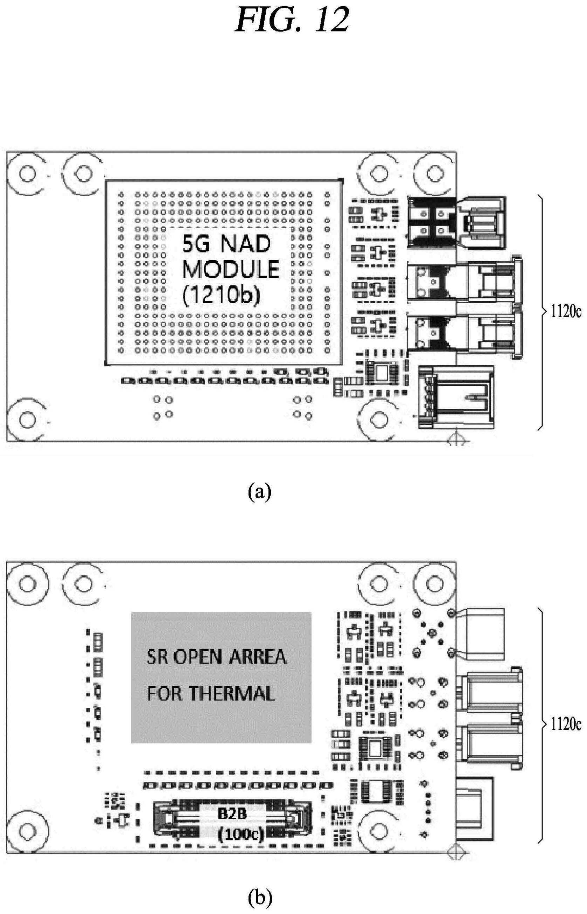

FIG. 12 illustrates a structure in which a plurality of electronic components are arranged on front and rear surfaces of the second PCB of the antenna structure according to this specification. (a) of FIG. 12 illustrates a structure in which a plurality of electronic components are arranged on the front surface of the second PCB of the antenna structure. (b) of FIG. 12 illustrates a structure in which a plurality of electronic components are arranged on the rear surface of the second PCB of the antenna structure.

Referring to FIGS. 4, 5, and 11, an ultra-wideband (UWB) module on which an antenna element 1110 is arranged, the V2X module 1130, the GNSS module 1140, the first Wi-Fi module 1160a, and the second Wi-Fi module 1160b may be arranged on a first surface of the PCB 1200. The application processor (AP) 1450 may be arranged on a second surface of the PCB 1200.

Referring to FIGS. 4, 5, and 12, the integrated circuit 1210b including a processor such as a network access device (NAD) may be arranged on a first surface of the second PCB 1200b. A thermal pad may be arranged on a second surface corresponding to a region in which the integrated circuit 1210b on the first surface of the second PCB 1200b is located. A second interface terminal 1120c may be arranged on one side of the second PCB 1200b.

Referring to FIGS. 4, 5, 11, and 12, the board-to-board connector structure 100c may be arranged to interconnect the PCB 1200 and the second PCB 1200b to each other. The board-to-board connector structure 100c may be configured to connect connection terminals of the PCB 1200 to connection terminals of the second PCB 1200b. The board-to-board connector structure 100c may be configured to connect connection terminals on the first surface of the PCB 1200 to the connection terminals of the second PCB 1200b.

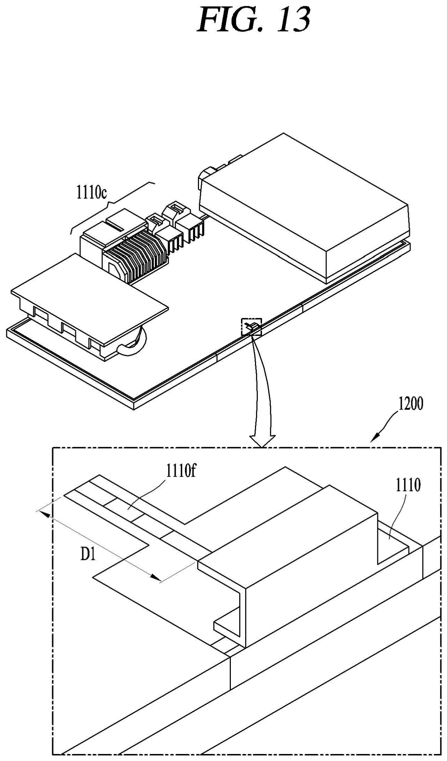

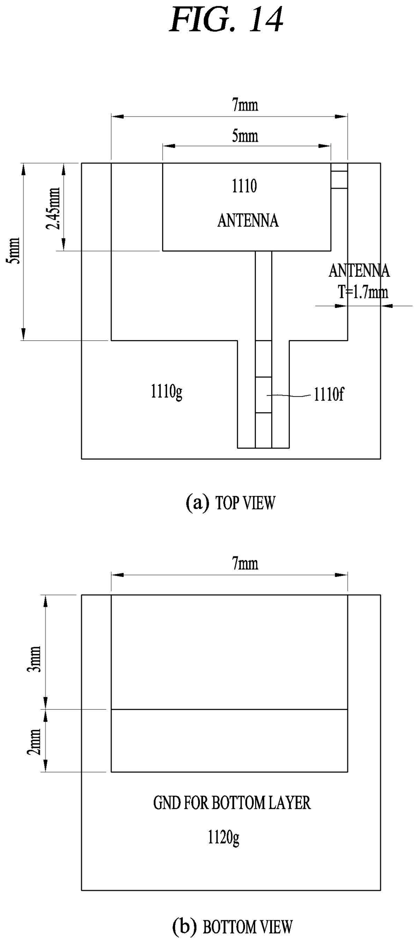

Meanwhile, the antenna element 1110 for ultra-wide band (UWB) communication may be arranged on the PCB 1200 of the antenna structure according to this specification. In this regard, FIG. 13 is an enlarged view of the PCB of the antenna structure according to this specification and a region in which the antenna element for UWB communication is arranged. FIG. 14 illustrates enlarged front and rear views of the region of the PCB in which the antenna element for UWB communication shown in FIG. 13 is arranged.

Referring to FIGS. 13 and 14, the PCB 1200 may be configured to include a plurality of interface terminals 1110c, the antenna element 1110, and a feed line 1110f. A ground plane 1110g may be arranged on a first surface of the PCB 1200 to surround a boundary of the antenna element 1110. The ground plane 1110g may be arranged on the first surface of the PCB 1200 to surround a boundary of the feed line 1110f. Accordingly, the feed line 1110f that feeds power to the antenna element 1110 may be configured to have a co-planar waveguide (CPW) structure such that the ground plane 1110g is arranged on both sides on a same plane. A ground plane 1120g may be arranged on a second surface of the PCB 1200. A dielectric region from which a conductive pattern is removed may be arranged on the second surface of the PCB 1200 to correspond to a region in which the antenna element 1110 is arranged.

The interface terminals 1110c may be arranged on a first side of the first surface of the PCB 1200. The antenna element 1110 may be arranged on a second side of the first surface of the PCB 1200. The ground plane 1120g may be arranged on the second surface of the PCB 1200. The ground planes 1110g and 1120g on the first and second surfaces of the PCB 1200 may be electrically connected to each other by vias which are vertically arranged. The feed line 1110f may be connected to one end portion of the antenna element 1110 so that a signal is input to the antenna element 1110 in a first direction D1. The feed line 1110f may be extended in the first direction D1 to be connected to the antenna element 1110.

Therefore, a first signal of the antenna element 1110 which operates in a 4G frequency band and is arranged on the PCB 1200 may be input in a first axis direction. On the other hand, signals from an antenna that operates in a 5G frequency band and is arranged on the second PCB 1200b may be input in a second axis direction. The first axis direction may be an X-axis direction and the second axis direction may be a Y-axis direction. However, the first axis direction and the second axis direction are not limited thereto and may vary depending on applications. The first axis direction and the second axis direction may be set to any directions substantially orthogonal to each other to correspond to a polarization direction of an antenna element.

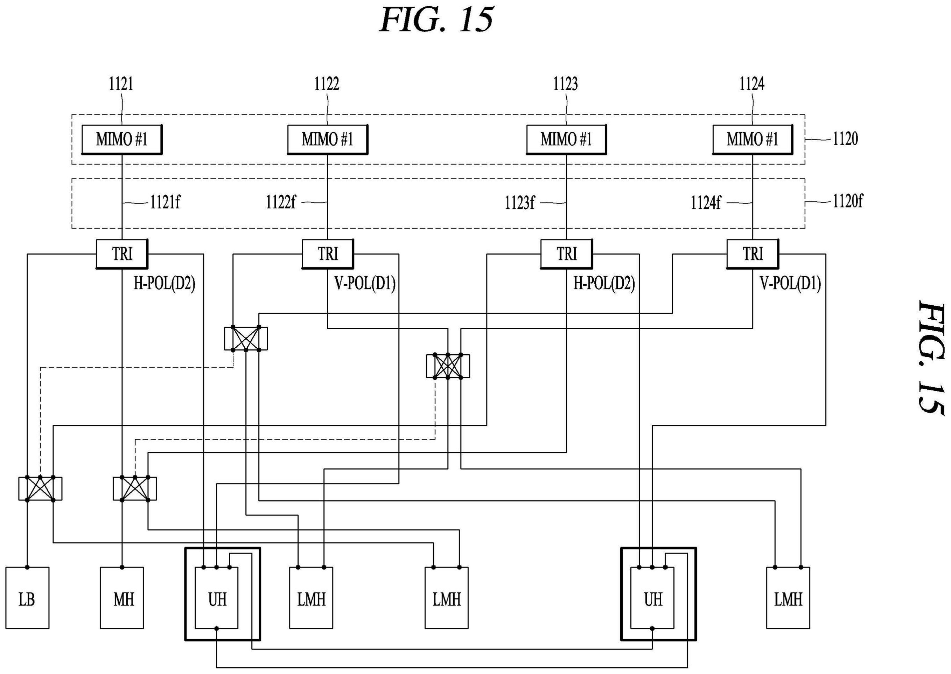

Meanwhile, the antenna elements 1120 for 4G/5G communication may be arranged on the second PCB 1200b of the antenna structure according to this specification. In this regard, FIG. 15 is a block diagram including a plurality of antenna elements for 4G/5G communications in the antenna structure according to this specification.

Referring to FIGS. 4 and 13 to 15, the second PCB 1200b may include the antenna elements 1120 and a plurality of feed lines 1120f. The antenna elements 1120 may be arranged on the first surface of the second PCB 1200b and configured to radiate signals to perform multiple input/output. The plurality of feed lines 1120f may be connected to one-end portions of the antenna elements 1120 so that second signals are input to the antenna elements 1120 in a second direction. At least one of the feed lines 1120f may extend in the second direction to be connected to at least one of the antenna elements 1120.

The plurality of antenna elements 1120 may be configured to include a first antenna element 1121, a second antenna element 1122, a third antenna element 1123, and a fourth antenna element 1124. The first antenna element 1121 may be configured to receive and/or transmit a first signal having a first polarization. The second antenna element 1122 may be configured to receive and/or transmit a second signal having a second polarization orthogonal to the first polarization. The third antenna element 1123 may be configured to receive and/or transmit a third signal having the first polarization. The fourth antenna element 1124 may be configured to receive and/or transmit a fourth signal having the second polarization. The first polarization may be configured as a horizontal polarization in the second direction D2. The second polarization may be configured as a vertical polarization in the first direction D2.

The first antenna element 1121 to the fourth antenna element 1124 may be connected to a feed line 1121f to a fourth feed line 1124, respectively. Accordingly, the plurality of feed lines 1120f may include the feed line 1121f, a second feed line 1122f, a third feed line 1123f, and the fourth feed line 1124.

The feed line 1121f may be electrically connected to the first antenna element 1121 to apply a first signal to the first antenna element 1121. The second feed line 1122f may be electrically connected to the second antenna element 1122 to apply a second signal to the second antenna element 1122. The third feed line 1123f may be electrically connected to the third antenna element 1123 to apply a third signal to the second antenna element 1123. The fourth feed line 1124f may be electrically connected to the fourth antenna element 1124 to apply a fourth signal to the fourth antenna element 1124.

A feed line connection structure for orthogonal polarizations may be used to improve isolation between adjacent antenna elements performing MIMO through the orthogonal polarizations, or to perform MIMO on a single antenna element. In this regard, the first and third feed lines 1121f and 1123f may be arranged in one direction among the first and second directions D1 and D2 to be connected to the first and third antenna elements 1121 and 1123. The second and fourth feed lines 1122f and 1124f may be arranged in another direction among the first and second directions D1 and D2 to be connected to the second and fourth antenna elements 1122 and 1124. Therefore, mutual interference between adjacent antenna elements may be reduced using the orthogonal polarizations. Meanwhile, a same polarization may be used between antenna elements spaced apart from each other by a certain distance or more.

The first antenna element 1121 to the fourth antenna element 1124 may be configured to operate in a first frequency band, a second frequency band, and a third frequency band. The second frequency band may be set to a higher band than the first frequency band. The third frequency band may be set to a higher band than the second frequency band. The first frequency band may be a low band (LB) for 4G/5G communications. The second frequency band may be a mid- and-high band (MHB) for 4G/5G communications. The third frequency band may be an ultra-high band (UHB) for 4G/5G communications. The first frequency band may be set to 617 to 960 MHz, but is not limited thereto and may be changed depending on applications. The second frequency band may be set to 1520 to 4500 MHz, but is not limited thereto and may be changed depending on applications. The third frequency band may be set to 4500 to 6000 MHz, but is not limited thereto and may be changed depending on applications.

Some of the antenna element 1110 arranged on the PCB 1200 and the antenna elements 1120 arranged on the second PCB 1200b may use orthogonal polarizations to reduce interferences in adjacent bands. In this regard, the antenna element 1110 arranged on the PCB 1200 may radiate a signal having the first polarization in a fourth frequency band. The first and third antenna elements 1121 and 1123 arranged on the second PCB 1200b may be configured to radiate signals having the second polarization in the third frequency band. As another example, the second and fourth antenna elements 1122 and 1124 arranged on the second PCB 1200b may be configured to radiate signals having the second polarization in the third frequency band.

The third frequency band may be the ultra-high band (UHB) for 4G/5G communications and set to 4500 to 6000 MHz. The fourth frequency band may be set as a frequency band for ultra-wideband (UWB) communications. The fourth frequency band may be a frequency band for UWB channel 5 and set to a band ranging from 6250 to 6750 MHz. The fourth frequency band may be a frequency band for UWB channel 9 and extend from 7750 to 8250 MHz.

Meanwhile, the second PCB 1200b may be configured to include the first to fourth antenna elements 1121 to 1124 and a plurality of electronic components. The second PCB 1200b may further include a first radio frequency integrated chip (RIFC) 1211b and a processor 1215. The second PCB 1200b may further include the array antenna 1150 for millimeter wave communication and a second RFIC 1212b. The first RIFC 1211b, the second RFIC 1212b, and the processor 1215 may be implemented as the integrated circuit 1210b.

The first RIFC 1211b may be operably coupled to the first to fourth antenna elements 1121 to 1124 to control signals applied to the first to fourth antenna elements 1121 to 1124. The processor 1215 may be operably coupled to the first RIFC 1211b to control the first RIFC 1211b.

The processor 1215 may perform a control operation in a first mode for transmitting or receiving a signal of the fourth frequency band through the antenna element 1110 arranged on the second PCB 1200b. The antenna element 1110 arranged on the second PCB 1200b may transmit or receive a signal having the first polarization. The processor 1215 may control the first RIFC 1211b to apply signals through the first and third antenna elements 1121 and 1123 having the second polarization. The processor 1215 may control the first RIFC 1211b not to apply signals through the second and fourth antenna elements 1122 and 1124 having the first polarization.

The array antenna 1150 may be configured to radiate a signal in a millimeter wave frequency band. The array antenna 1150 may be configured to generate a wireless beamforming signal in the millimeter wave frequency band through a plurality of antenna elements. The array antenna 1150 may also perform a multiple input/multiple output (MIMO) or diversity operation through the plurality of array antennas.

The second RFIC 1212b may be operably coupled to the array antenna 1150 and control a magnitude and a phase of a signal applied to each antenna element of the array antenna 1150. The processor 1215 may be operably coupled to the first RIFC 1211b and the second RIFC 1212b and configured to control the first RIFC 1211b and the second RIFC 1212b.

The PCB 1200 may be configured to include a plurality of antenna/communication modules and a processor in addition to the antenna element 1110. The PCB 1200 may include the first antenna structure 1110a, the second antenna structure 1110b, the V2X module 1130, the GNSS module 1140, the first Wi-Fi module 1160a, the second Wi-Fi module 1160b, and the application processor (AP) 1450.

The first antenna structure 1110a may be configured to include a V2X antenna and a GNSS antenna. The first antenna structure 1110a may further include an SXM antenna, an AM/FM antenna, and an FM/DAB antenna each for broadcast services. The second antenna structure 1110b may be arranged to be spaced apart from the first antenna structure 1110a. The second antenna structure 1110b may include a V2X antenna and first and second Wi-Fi antennas. The second antenna structure 1110b may further include a BLE antenna.

The V2X module 1130 may be configured to be coupled to V2X antennas of the first and second antenna structures 1110a and 1110b. The V2X module 1130 may be configured to include an RFIC and a modem. The GNSS module 1140 may be coupled to the GNSS antenna of the first antenna structure 1110a and configured to control a signal applied to the GNSS antenna. The first Wi-Fi module 1160a may be coupled to a first Wi-Fi antenna of the second antenna structure 1110b and configured to control a signal applied to the first Wi-Fi antenna. The second Wi-Fi module 1160b may be coupled to a second Wi-Fi antenna of the second antenna structure 1110b and configured to control a signal applied to the second Wi-Fi antenna.

The application processor 1450 may be operably coupled to the V2X module 1130, the GNSS module 1140, the first Wi-Fi module 1160a, and the second Wi-Fi module 1160b. The application processor 1450 may be configured to control a signal applied to each of the V2X module 1130, the GNSS module 1140, the first Wi-Fi module 1160a, and the second Wi-Fi module 1160b.

Meanwhile, interface terminals arranged on the PCB 1200 and interface terminals arranged on the second PCB 1200b may be coupled to each other on a same plane. In this regard, a first connector arranged on the PCB 1200 and a second connector arranged on the second PCB 1200b may be coupled to each other at a same height on a Z-axis to constitute the board-to-board connector structure 100c. Accordingly, the first connector arranged on the PCB 1200 and the second connector arranged on the second PCB 1200b may be coupled to each other on a same plane.

The V2X module 1130 may be coupled to the processor 1215 of the second PCB 1200b through the board-to-board connector structure 100c. The GNSS module 1140, the first Wi-Fi module 1160a, and the second Wi-Fi module 1160b may be coupled to the processor 1215 of the second PCB 1200b through the application processor 1450 via the board-to-board connector structure 100c. Accordingly, processors may be shared on the PCBs 1200 and 1200b which are different from each other, and electronic components may be controlled in common with each other.

Meanwhile, a plurality of interface terminals may be arranged in different regions of the antenna structure 1000 mounted on the vehicle. The interface terminals 1110c of the PCB 1200 may be located on a first side of and the second cover 1320. The second PCB 1200b may include the array antenna 1150 operating in a millimeter wave band and second interface terminals 1120c that interface with the first to fourth antenna elements 1121 to 1124. The second interface terminals 1120c of the second PCB 1200b may be arranged on a first side of the third cover 1330. The first side of the second cover 1320 and the first side of the third cover 1330 may be arranged on a plane that is arranged horizontally. The first side of the second cover 1320 and the third cover 1330 may be arranged on an XY plane on a same plane.

The interface terminals 1110c may also include first to fourth terminals 1111c to 1114c. The first terminal 1111c is an interface terminal for Ethernet and may be implemented by four pins. One among the second terminals 1112c is an interface terminal associated with a battery power key, a car area network (CAN), and a light-emitting diode (LED), and may be implemented by 29 pins. Another one among the second terminals 1112c is an interface terminal associated with audio charging and debugging, and may be implemented with 29 pins. The third terminal 1113c is an interface terminal associated with the first and second Wi-Fi modules 1160a and 1160b, the V2X module 1130, and a BLE module, and may be implemented by six pins. The fourth terminal 1114c is an interface terminal associated with the V2X module 1130, the BLE module, and a broadcast service module, and may be implemented by six pins.

The second interface terminals 1120c may include fifth to eighth terminals 1121c to 1124c. The fifth terminal 1121c is an interface terminal associated with the first to fourth antenna elements 1121 to 1124 arranged on the second PCB 1200b, and may be implemented by four pins. The sixth terminal 1122c is an interface terminal associated with a first mmWave module (first array antenna) arranged on the second PCB 1200b, and may be implemented by one pin. The seventh terminal 1123 is an interface terminal associated with a second mmWave module (second array antenna) placed on the second PCB 1200b, and may be implemented by one pin. The eighth terminal 1124c is an interface terminal associated with a power source that controls electronic components operating in a mmWave band and may be implemented by four pins.

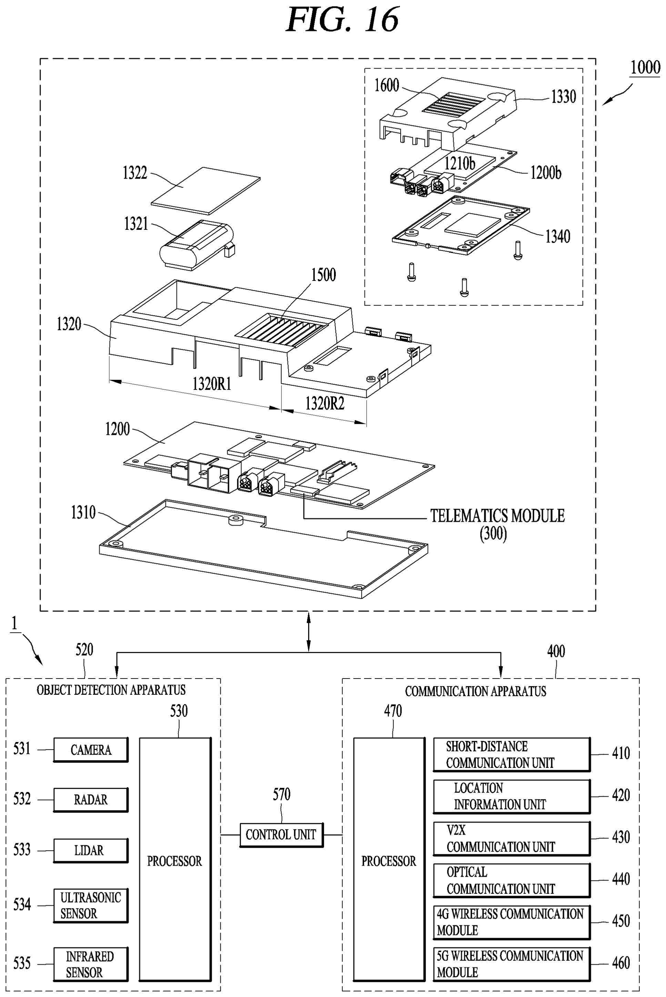

The vehicle antenna structure according to one aspect of this specification has been described above. Hereinafter, a vehicle on which an antenna structure according to another aspect of this specification is mounted is to be described. In this regard, FIG. 16 is a configuration diagram of a vehicle including the antenna structure according to this specification.

Referring to FIGS. 1 and 16, the antenna structure 1000 may perform short-range communication, wireless communication, V2X communication, etc. independently or through a communication device 400. To do so, a processor 1400 may control to receive or transmit a signal from/to an adjacent vehicle, a road side unit (RSU), and a base station through the antenna structure 1000.

The processor 1400 may control to receive or transmit a signal from/to an adjacent vehicle, an RSU, an adjacent object, and a base station through the communication device 400. Here, information related to the adjacent object may be acquired through an object detection device 520 such as a camera 531, a radar 532, a LiDar 533, sensors 534 and 535, or the like, each included in the vehicle 1. Alternatively, the processor 1400 may control the communication device 400 and the antenna structure 1000 to receive or transmit a signal from/to an adjacent vehicle, an RSU, an adjacent object, and a base station.

The vehicle 1 may include the antenna structure 1000 and a telematics module 300. The telematics module 300 may be arranged on the second surface of the PCB 1200, but is not limited thereto and may be changed depending on applications. The telematics module 300 may be configured to include an RFIC which is a transceiver circuit, and the processor 1400. The antenna structure 1000 may be arranged below a roof of the vehicle 1. The telematics module 300 may be operably coupled to the antenna structure 1000. The telematics module 300 may be configured to communicate with at least one among an adjacent vehicle, a road side unit (RSU), and a base station.

The antenna structure 1000 may be configured to include the PCB 1200, the second PCB 1200b, the first cover 1310, the second cover 1320, the third cover 1330, the first heat sink 1500, and the second heat sink 1600. The PCB 1200 may be configured to have electronic components of the first communication system arranged thereon. The second PCB 1200b may be operably coupled to the PCB 1200. The second PCB 1200b may be configured to have electronic components of the second communication system arranged thereon. The first communication system may include at least one among an LTE communication system, a V2X communication system, and a BT/WiFi communication system. The second communication system may include at least one among a 4G/5G communication system and a mmWave communication system utilizing a millimeter wave band.

The first cover 1310 may be arranged below the PCB 1200. The first cover 1310 may include a metal plate and be coupled to a structure of the vehicle. The second cover 1320 may be coupled to the first cover 1310 which is a lower cover. The second cover 1320 may be configured to have the PCB 1200 accommodated therein. The second cover 1320 may be configured to include the first region 1320R1 and the second region 1320R2.

The third cover 1330 may be coupled to the second region 1320R2 of the second cover 1320. The third cover 1330 may be configured to have the second PCB 1200b accommodated therein.

The antenna structure 1000 may be configured to include the first heat sink 1500 and the second heat sink 1600. The first heat sink 1500 may be arranged in a first opening area of the first region 1320R1 of the second cover 1320. The second heat sink 1600 may be arranged in a second opening area of the third cover 1330.

The first heat sink 1500 may be configured to include the first metal structure 1510 and the second metal structures 1520. The first heat sink 1500 may be configured to further include the third metal structure 1530.

The first metal structure 1510 may be stacked in the Z-axis direction to be in contact with the shield can 1211 of the integrated circuit 1210 of the PCB 1200. The thermal pad 1212 may be placed between the integrated circuit 1210 and the shield can 1211. The thermal pad 1212 may transfer heat, generated from the integrated circuit 1210, to the first heat sink 1500 through the shield can 1211. The second metal structures 1520 may be arranged to be perpendicular to the first metal structure 1510. The second metal structures 1520 may be arranged in plurality in a first direction along the Y-axis direction.

The third metal structure 1530 may be configured to connect end portions of the first metal structure 1510 to the both side surfaces S1a and S1b of the first opening area (aperture region) AR1. The third metal structure 1530 may be arranged to be inclined to connect the end portions of the first metal structure 1510 to the both side surfaces S1a and S1b of the first opening area AR1.

The second heat sink 1600 may be configured to include the fourth metal structure 1610 and the fifth metal structures 1620. The second heat sink 1600 may be configured to further include the sixth metal structure 1630. The second heat sink 1600 may be configured to further include the seventh metal structure 1640.

The fourth metal structure 1610 may be stacked in the Z-axis direction to be in contact with the shield can 1211b of the integrated circuit 1210b of the second PCB 1200b. The thermal pad 1212a may be arranged between the fourth metal structure 1610 and the shield can 1211b. The thermal pad 1212b may be arranged between the integrated circuit 1210b and the shield can 1211b. The integrated circuit 1210b may be arranged on the third PCB 1200c, and the third PCB 1200c covered by the shield can 1211b may be arranged on the second PCB 1200b. The thermal pads 1212a and 1212b may transfer heat, generated from the integrated circuit 1210b, to the second heat sink 1600 through the shield can 1211b.

The fifth metal structures 1620 may be connected to the fourth metal structure 1610. The fifth metal structures 1620 may be arranged in plurality in parallel with each other in a second direction different from the first direction. The fifth metal structures 1620 may be arranged in plurality in parallel with each other in the second direction along the X-axis direction.

The sixth metal structure 1630 may be arranged to connect end portions of the fourth metal structure 1610 to the both side surfaces S2a and S2b of the second opening area AR2. The sixth metal structure 1630 may be arranged to be inclined to connect the end portions of the fourth metal structure 1610 to the both side surfaces S2a and S2b of the second opening area AR2. The sixth metal structure 1630 may include an inner structure arranged in an inner region, an outer structure arranged in an outer region, and a connection structure connecting the inner structure to the outer structure. The fifth metal structures 1620 may define the connection structure of the sixth metal structure 1630.

The outer structure of the sixth metal structure 1630 may have lower portions coupled to both end portions of the seventh metal structure 1640. The seventh metal structure 1640 may be arranged to be parallel with the fourth metal structure 1610 to constitute a bottom surface. The thermal pad 1212c may be arranged between the second PCB 1200b and the seventh metal structure 1640. The thermal pad 1212c may transfer heat, generated from the second PCB 1200b on which the integrated circuit 1210b is placed, to the second heat sink 1600 including the seventh metal structure 1640.

The second metal structures 1520 of the first heat sink 1500 may be arranged in plurality in a first direction in which a first signal of the first communication system is input. The fifth metal structures 1620 of the second heat sink 1600 may be arranged in plurality in a second direction in which second signals of the second communication system are input. The first direction of the second metal structures 1520 of the first heat sink 1500 may be configured as the Y-axis direction. The second direction of the fifth metal structures 1620 of the second heat sink 1600 may be configured as the X-axis direction perpendicular to the first direction.

The PCB 1200 may be configured to include the plurality of interface terminals 1110c, the antenna element 1110, and the feed line 1110f. The interface terminals 1110c may be arranged on a first side of the first surface of the PCB 1200. The antenna element 1110 may be arranged on a second side of the first surface of the PCB 1200. The ground plane 1120g may be arranged on the second surface of the PCB 1200. The ground planes 1110g and 1120g on the first and second surfaces of the PCB 1200 may be electrically connected to each other by vias which are vertically arranged. The feed line 1110f may be connected to one end portion of the antenna element 1110 so that a signal is input to the antenna element 1110 in the first direction D1. The feed line 1110f may be extended in the first direction D1 to be connected to the antenna element 1110.

The second PCB 1200b may include the antenna elements 1120 and the plurality of feed lines 1120f. The antenna elements 1120 may be arranged on the first surface of the second PCB 1200b and configured to radiate signals to perform multiple input/output. The plurality of feed lines 1120f may be connected to one-end portions of the antenna elements 1120 so that second signals are input to the antenna elements 1120 in the second direction. At least one of the feed lines 1120f may extend in the second direction to be connected to at least one of the antenna elements 1120.

The plurality of antenna elements 1120 may be configured to include the first antenna element 1121, the second antenna element 1122, the third antenna element 1123, and the fourth antenna element 1124. The first antenna element 1121 may be configured to receive and/or transmit a first signal having a first polarization. The second antenna element 1122 may be configured to receive and/or transmit a second signal having a second polarization orthogonal to the first polarization. The third antenna element 1123 may be configured to receive and/or transmit a third signal having the first polarization. The fourth antenna element 1124 may be configured to receive and/or transmit a fourth signal having the second polarization. The first polarization may be configured as a horizontal polarization in the second direction D2. The second polarization may be configured as a vertical polarization in the first direction D2.

The first antenna element 1121 to the fourth antenna element 1124 may be configured to operate in a first frequency band, a second frequency band, and a third frequency band. The second frequency band may be set to a higher band than the first frequency band. The third frequency band may be set to a higher band than the second frequency band.

Some of the antenna element 1110 arranged on the PCB 1200 and the antenna elements 1120 arranged on the second PCB 1200b may use orthogonal polarizations to reduce interferences in adjacent bands. In this regard, the antenna element 1110 arranged on the PCB 1200 may radiate a signal having the first polarization in a fourth frequency band. The first and third antenna elements 1121 and 1123 arranged on the second PCB 1200b may be configured to radiate signals having the second polarization in the third frequency band. As another example, the second and fourth antenna elements 1122 and 1124 arranged on the second PCB 1200b may be configured to radiate signals having the second polarization in the third frequency band.

The third frequency band may be the ultra-high band (UHB) for 4G/5G communications and set to 4500 to 6000 MHz. The fourth frequency band may be set as a frequency band for ultra-wideband (UWB) communications. The fourth frequency band may be a frequency band for UWB channel 5 and set to a band ranging from 6250 to 6750 MHz. The fourth frequency band may be a frequency band for UWB channel 9 and extend from 7750 to 8250 MHz.

Meanwhile, the second PCB 1200b may be configured to include the first to fourth antenna elements 1121 to 1124 and a plurality of electronic components. The second PCB 1200b may further include the first RIFC 1211b and the processor 1215. The second PCB 1200b may further include the array antenna 1150 for millimeter wave communication and the second RFIC 1212b. The first RIFC 1211b, the second RFIC 1212b, and the processor 1215 may be implemented as the integrated circuit 1210b.

The first RIFC 1211b may be operably coupled to the first to fourth antenna elements 1121 to 1124 to control signals applied to the first to fourth antenna elements 1121 to 1124. The processor 1215 may be operably coupled to the first RIFC 1211b to control the first RIFC 1211b.

The processor 1215 may perform a control operation in a first mode for transmitting or receiving a signal of the fourth frequency band through the antenna element 1110 arranged on the second PCB 1200b. The antenna element 1110 arranged on the second PCB 1200b may transmit or receive a signal having the first polarization. The processor 1215 may control the first RIFC 1211b to apply signals through the first and third antenna elements 1121 and 1123 having the second polarization. The processor 1215 may control the first RIFC 1211b not to apply signals through the second and fourth antenna elements 1122 and 1124 having the first polarization.

The antenna structure mounted on a vehicle and the vehicle including the same have been described above. Hereinafter, technical effects of such an antenna structure mounted on a vehicle and the vehicle including the antenna structure are described.

According to this specification, an antenna structure having a plurality of communication modules and a heat dissipation structure may be provided in a vehicle.

According to this specification, an optimal heat dissipation structure may be implemented by taking into account arrangement structures of communication modules placed on different substrates.

According to this specification, a direction in which metal structures of first and second heat sinks are arranged may be configured to be aligned with a polarization direction of an antenna to implement optimal heat dissipation performance.

According to this specification, an interface structure and a board-to-board connector structure each for signal and power connections between substrates having different electronic components arranged thereon may be provided.

According to this specification, in an antenna structure, upper end portions of a second cover and a third cover which are coupled to a first cover in different regions, respectively, may be configured to be located at a same height, thereby improving antenna performance while maintaining a height of the antenna structure mounted on a vehicle at a certain level or below.

According to this specification, an antenna structure in which antenna elements capable of operating in a wide band are optimally arranged on different printed circuit boards (PCBs) may be applied to a vehicle to support various communication systems.

Further scope of applicability of the present disclosure will become apparent from the following detailed description. It should be understood, however, that the detailed description and specific examples, such as the preferred embodiment of the present disclosure, are given by way of illustration only, since various changes and modifications within the spirit and scope of the present disclosure will be apparent to those skilled in the art.

In relation to the foregoing description, the antenna system mounted in the vehicle and the operation of controlling the same may be implemented by software, firmware, or a combination thereof. Meanwhile, the design of the antenna system mounted in the vehicle and the configuration of controlling the antenna system may be implemented as computer-readable codes in a program-recorded medium. The computer-readable medium may include all types of recording devices each storing data readable by a computer system. Examples of such computer-readable media may include hard disk drive (HDD), solid status disk (SSD), silicon disk drive (SDD), ROM, RAM, CD-ROM, magnetic tape, floppy disk, optical data storage element and the like. Also, the computer-readable medium may also be implemented as a format of carrier wave (e.g., transmission via an Internet). The computer may also include a controller of a terminal or vehicle, namely, a processor. Therefore, the detailed description should not be limitedly construed in all of the aspects, and should be understood to be illustrative. The scope of the present disclosure should be determined by reasonable interpretation of the appended claims, and all changes within the scope of equivalents of the present disclosure are included in the scope of the present disclosure.

## Claims

1. An antenna structure mounted on a vehicle, the antenna structure comprising:
a printed circuit board (PCB) on which electronic components of a first communication system are arranged;
a first cover arranged below the PCB and made of a metal plate;
a second cover coupled to the first cover and configured to accommodate the PCB therein;
a second PCB operably coupled to the PCB and having electronic components of a second communication system arranged thereon;
a first heat sink arranged in a first opening area of a first region of the second cover;
a third cover coupled to a second region of the second cover and configured to accommodate the second PCB therein; and
a second heat sink arranged in a second opening area of the third cover.

2. The antenna structure of claim 1, wherein the first heat sink comprises:
a first metal structure stacked to be in contact with a shield can of an integrated circuit of the PCB; and
second metal structures arranged to be perpendicular to the first metal structure and configured in plurality in a first direction;
a third metal structure arranged to be inclined to connect end portions of the first metal structure to both side surfaces of the first opening area.

3. The antenna structure of claim 2, wherein the second heat sink comprises:
a fourth metal structure stacked to be in contact with a shield can of an integrated circuit of the second PCB;
fifth metal structures connected to the fourth metal structure and configured in plurality to be parallel with each other in a second direction different from the first direction; and
a sixth metal structure arranged to be inclined to connect end portions of the fourth metal structure to both side surfaces of the second opening area.

4. The antenna structure of claim 3, wherein the second metal structures are configured in plurality in the first direction in which a first signal of the first communication system is input,
the fifth metal structures are configured in plurality in the second direction in which second signals of the second communication system are input, and
the first direction is configured in a Y-axis direction and the second direction is configured in an X-axis direction perpendicular to the first direction.

5. The antenna structure of claim 1, wherein the second region of the second cover is configured to have a smaller height than a height of the first region of the second cover to cause the second cover to be configured in a recessed region,
the second PCB and the third cover are arranged in the recessed region, and
an upper end portion of the second cover is arranged at a same point on a Z-axis as an upper end portion of the third cover.

6. The antenna structure of claim 4, wherein the PCB comprises:
interface terminals arranged on a first side of a first surface;
an antenna element arranged on a second side of the first surface; and
a feed line connected to one end portion of the antenna element to cause a signal to be input to the antenna element in the first direction, and
wherein the feed line extends in the first direction to be connected to the antenna element.

7. The antenna structure of claim 6, wherein the second PCB comprises a plurality of antenna elements arranged on a first surface and configured to perform multiple input multiple output (MIMO), and
wherein the plurality of antenna elements comprises:
a first antenna element configured to receive a first signal having a first polarization;
a second antenna element configured to receive a second signal having a second polarization orthogonal to the first polarization;
a third antenna element configured to receive a third signal having the first polarization; and
a fourth antenna element configured to receive a fourth signal having the second polarization.

8. The antenna structure of claim 7, comprising:
a first feed line electrically connected to the first antenna element to apply the first signal to the first antenna element; and
a feed line electrically connected to the second antenna element to apply the second signal to the second antenna element; and
a third feed line electrically connected to the third antenna element to apply the third signal to the third antenna element; and
a fourth feed line electrically connected to the fourth antenna element to apply the fourth signal to the fourth antenna element,
wherein the first and third feed lines are arranged in the first direction to be connected to the first and third antenna elements, and
the second and fourth feed lines are arranged in the second direction to be connected to the second and fourth antenna elements.

9. The antenna structure of claim 7, wherein the first to fourth antenna elements are configured to operate in a first frequency band, a second frequency band, and a third frequency band,
the second frequency band is a higher band than the first frequency band, and the third frequency band is higher than the second frequency band,
the antenna element arranged on the PCB radiates a signal having the first polarization in the fourth frequency band, and
the first and third antenna elements arranged on the second PCB are configured to radiate signals having the second polarization.

10. The antenna structure of claim 9, wherein the second PCB further comprises a first radio frequency integrated chip (RIFC) operably coupled to the first to fourth antenna elements, and a processor operably coupled to the first RIFC, and
in a first mode of transmitting or receiving a signal of the fourth frequency band through the plurality of antenna elements arranged on the second PCB, the processor controls signals to be applied through the first and third antenna elements and controls signals not to be applied through the second and fourth antenna elements.

11. The antenna structure of claim 10, wherein the second PCB further comprises:
an array antenna configured to radiate a signal in a millimeter wave frequency band; and
a second RIFC operably coupled to the array antenna, and
wherein the processor is configured to control the first RFIC and the second RIFC.

12. The antenna structure of claim 11, wherein the PCB further comprises:
a first antenna structure comprising a vehicle-to-everything (V2X) antenna and a global navigation satellite system (GNSS) antenna;
a second antenna structure comprising a V2X antenna, and first and second Wi-Fi antennas;
a V2X module coupled to the V2X antennas of the first and second antenna structures;
a GNSS module coupled to the GNSS antenna of the first antenna structure;
a first Wi-Fi module coupled to the first Wi-Fi antenna of the second antenna structure;
a second Wi-Fi module coupled to the second Wi-Fi antenna of the second antenna structure; and
an application processor operably coupled to the V2X module, the GNSS module, the first Wi-Fi module, and the second Wi-Fi module.

13. The antenna structure of claim 12, wherein a first connector arranged on the PCB and a second connector arranged on the second PCB are vertically coupled to each other to constitute a board-to-board connector structure.

14. The antenna structure of claim 13, wherein the V2X module is coupled to the processor of the second PCB through the board-to-board connector structure, and
the GNSS module, the first Wi-Fi module and the second Wi-Fi module are coupled to the processor of the second PCB through the application processor via the board-to-board connector structure.

15. The antenna structure of claim 7, wherein the interface terminals of the PCB are arranged on a first side of the second cover,
the second PCB comprises an array antenna operating in a millimeter wave band and second interface terminals interfaced with the first to fourth antenna elements,
the second interface terminals of the second PCB are arranged on a first side of the third cover, and
the first side of the second cover and the first side of the third cover are arranged on a plane that is arranged horizontally.

16. A vehicle having an antenna structure mounted thereon, the vehicle comprising:
an antenna structure arranged below a roof of the vehicle; and
a telematics module operably coupled to the antenna structure and configured to communicate with at least one among an adjacent vehicle, a road side unit (RSU), and a base station,
wherein the antenna structure comprises:
a printed circuit board (PCB) on which electronic components of a first communication system are arranged;
a first cover arranged below the PCB and made of a metal plate;
a second cover coupled to the first cover and configured to accommodate the PCB therein;
a second PCB operably coupled to the PCB and having electronic components of a second communication system arranged thereon;
a first heat sink arranged in a first opening area of a first region of the second cover;
a third cover coupled to a second region of the second cover and configured to accommodate the second PCB therein; and
a second heat sink arranged in a second opening area of the third cover.

17. The vehicle of claim 16, wherein the first heat sink comprises:
a first metal structure stacked to be in contact with a shield can of an integrated circuit of the PCB; and
second metal structures arranged to be perpendicular to the first metal structure and configured in plurality in a first direction; and
a third metal structure arranged to be inclined to connect end portions of the first metal structure to both side surfaces of the first opening area.

18. The vehicle of claim 17, wherein the second heat sink comprises:
a fourth metal structure stacked to be in contact with a shield can of an integrated circuit of the second PCB;
fifth metal structures connected to the fourth metal structure and configured in plurality to be parallel with each other in a second direction different from the first direction; and
a sixth metal structure arranged to be inclined to connect end portions of the fourth metal structure to both side surfaces of the second opening area,
wherein the second metal structures are configured in plurality in the first direction in which a first signal of the first communication system is input,
the fifth metal structures are configured in plurality in the second direction in which second signals of the second communication system are input, and
the first direction is configured in a Y-axis direction and the second direction is configured in an X-axis direction perpendicular to the first direction.

19. The vehicle of claim 18, wherein the PCB comprises:
interface terminals arranged on a first side of a first surface;
an antenna element arranged on a second side of the first surface; and
a feed line connected to one end portion of the antenna element to cause a signal to be input to the antenna element in the first direction, and
wherein the feed line extends in the first direction to be connected to the antenna element,
the second PCB comprises a plurality of second antenna elements arranged on a first surface and configured to perform multiple input multiple output (MIMO), and
wherein the plurality of antenna elements comprises:
a first antenna element configured to receive a first signal having a first polarization;
a second antenna element configured to receive a second signal having a second polarization orthogonal to the first polarization;
a third antenna element configured to receive a third signal having the first polarization; and
a fourth antenna element configured to receive a fourth signal having the second polarization.

20. The vehicle of claim 19, wherein the first to fourth antenna elements are configured to operate in a first frequency band, a second frequency band, and a third frequency band,
the second frequency band is a higher band than the first frequency band, and the third frequency band is higher than the second frequency band,
the antenna element arranged on the PCB radiates a signal having the first polarization in the fourth frequency band, and
the first and third antenna elements arranged on the second PCB are configured to radiate signals having the second polarization, and
wherein the second PCB further comprises a first radio frequency integrated chip (RIFC) operably coupled to the first to fourth antenna elements, and a processor operably coupled to the first RIFC, and
in a first mode of transmitting or receiving a signal of the fourth frequency band through the plurality of antenna elements arranged on the second PCB, the processor controls signals to be applied through the first and third antenna elements and controls signals not to be applied through the second and fourth antenna elements.
